# EUROPEAN PATENT SPECIFICATION

(11) **EP 3 477 387 B1**
(45) Date of publication and mention of the grant of the patent: **17.12.2025**
(21) Application number: 17819962.6
(22) Date of filing: 20.06.2017
(51) Int. Cl.: G03F 1/62, G03F 1/64

(54) **PELLICLE FILM, PELLICLE FRAME BODY, PELLICLE, AND METHOD FOR MANUFACTURING PELLICLE**
PELLIKELFOLIE, PELLIKELRAHMENKÖRPER, PELLIKEL UND VERFAHREN ZUR PELLIKELHERSTELLUNG
FILM DE PELLICULE, CORPS DE CADRE DE PELLICULE, PELLICULE, ET PROCÉDÉ DE FABRICATION D'UNE PELLICULE

(30) Priority: 28.06.2016 JP 2016127535
(43) Date of publication of application: 01.05.2019
(73) Proprietor: Mitsui Chemicals, Inc., Tokyo 104-0028 (JP)
(72) Inventor: OKUBO Atsushi, Sodegaura-shi Chiba 299-0265 (JP); ONO Yosuke, Sodegaura-shi Chiba 299-0265 (JP); KOHMURA Kazuo, Sodegaura-shi Chiba 299-0265 (JP); FUJII Yasuhisa, Kyoto-shi Kyoto 600-8813 (JP); YOSHIKAWA Wataru, Kyoto-shi Kyoto 600-8813 (JP)
(74) Representative: Hoffmann Eitle
(86) International application number: PCT/JP2017/022688
(87) International publication number: WO 2018/003603

(56) References cited:
- WO-A1-2016/043301
- WO-A1-2017/036944
- JP-A- 2001 133 959
- JP-A- 2010 541 267
- JP-A- 2013 004 893
- JP-U- H0 342 153
- US-A1- 2011 065 278
- US-A1- 2015 168 824
- US-A1- 2016 048 079
- US-B2- 9 057 957

## Description

### TECHNICAL FIELD

The present invention relates to a method for producing a pellicle usable for a mask for photolithography.

### BACKGROUND ART

In a photolithography process, in order to prevent dust or the like from being attached to a mask or a reticle, a pellicle including a pellicle film extended along one end of a frame having a size appropriate to enclose a mask pattern is used.

A pellicle is used to protect a photomask against foreign substances such as dust or the like. If a produced pellicle has dust or the like attached thereto, it is meaningless to use the pellicle. Therefore, a pellicle decreased in the amount of dust or the like attached thereto and a method for producing the same are currently strongly desired.

So far, the wavelength of light used for lithography has been progressively shortened. As a next-generation lithography technology, EUV lithography is now being developed. "EUV light" refers to light having a wavelength in a soft x-ray range or a vacuum ultraviolet range, more specifically, a light beam having a wavelength of about 13.5 nm ± about 0.3 nm. In photolithography, the resolution limit of a pattern is about 1/2 of the exposure wavelength and is considered to be about 1/4 of the exposure wavelength even if an immersion method is used, and even if an immersion method is used with ArF laser light (wavelength: 193 nm), the exposure wavelength is expected to be about 45 nm at the minimum. In such a situation, EUV lithography is anticipated as a revolutionary technology that realizes significant reduction in the resolution limit as compared with the conventional lithography.

EUV light is easily absorbed by any substance. Therefore, especially, a pellicle for EUV needs to include a pellicle film having a thickness of a nanometer order, which is not provided conventionally.

A pellicle for EUV, which needs to use such an extremely thin film, is generally obtained as follows as described in Patent Literature 1. A pellicle film is formed on a substrate such as a silicon substrate or the like by CVD, sputtering or any other appropriate film formation method, and then, only the substrate is removed by etching or the like (back-etching) while a peripheral frame-like region of the substrate is left.

In order to achieve an aim of producing a pellicle with little dust, various problems have been investigated and various attempts have been made to solve the problems. For example, Patent Document 2 describes a pellicle including at least one air hole formed in a pellicle frame and a filter member provided in the air hole. The filter member prevents dust or the like from passing the air hole and is provided so as not to fall into a space enclosed by a frame member, a mask substrate and a pellicle film. It should be noted that this invention does not relate to a pellicle for EUV and is not sufficient from the point of view of decreasing the dust.
Patent Document 3 discloses an optical membrane element for an optical device in lithography, especially EUV lithography, with at least one membrane layer and a frame, which at least partially surrounds the membrane layer.
Patent Document 4 describes a method for fabricating a pellicle, wherein an insulation layer is formed over a silicon substrate, a mesh is formed over the insulation layer, the center portion of the silicon substrate is selectively removed to form a frame that exposes a rear surface of the insulation layer, a membrane is deposited over the mesh and over an exposed top surface of the insulation layer which is adjacent to the mesh, and the portion of the insulation layer which is exposed by the frame is selectively removed to expose a rear surface of the membrane layer.

### CITATION LIST

### PATENT LITERATURE

Patent Literature 1: Japanese Laid-Open Patent Publication No. 2013-004893
Patent Literature 2: Japanese Utility Model Publication for Opposition No. Sho 63-39703
Patent Literature 3: Japanese Laid-Open Patent Publication No. 2010-541267
Patent Literature 4: United States Laid-Open Patent Publication No. 2011/065278

### SUMMARY OF INVENTION

### TECHNICAL PROBLEM

A pellicle may be contaminated with dust or the like for various reasons during the production thereof. Especially, there is a problem that the risk that the dust or the like is attached is high during trimming, various processes performed on the pellicle film, transportation or the like. The present invention has an object of providing a method for producing a pellicle for EUV decreased in the amount of dust or the like attached thereto.

### SOLUTION TO PROBLEM

Provided in order to achieve the above-described object is a method for producing a pellicle including forming a pellicle film on a substrate; forming a metal mask on a surface of the substrate opposite to a surface having the pellicle film formed thereon; removing a part of the substrate from the side of the metal mask; and removing the metal mask.

In an embodiment according to the present invention, the method may further include forming a surface metal coating layer between the substrate and the pellicle film.

In an embodiment according to the present invention, the metal mask may be formed of chromium. In an embodiment according to the present invention, the surface metal coating layer may be formed of ruthenium.

In an embodiment according to the present invention, a step of the removal of the part of the substrate is performed by a step of wet etching.

In an embodiment according to the present invention, before the part of the substrate is removed, particles attached to at least a surface of the pellicle film may be removed.

In an embodiment, before the part of the substrate is removed, an end portion of the substrate may be chamfered.

In an embodiment, before the particles are removed, a hole may be formed in at least the substrate.

In an embodiment, before the particles are removed, a hole may be formed in at least the pellicle film and the substrate.

In an embodiment, before the particles are removed, a hole may be formed in at least the pellicle film.

In an embodiment, ultra-short pulse laser light may be used to form the hole.

In an embodiment, the removal of the part of the substrate is performed by wet etching, and the hole may be formed by wet etching.

In an embodiment, ultra-short pulse laser light may be used for trimming.

Disclosed is a pellicle frame including a pellicle film; and a first frame. The pellicle film is extended over the first frame; and the first frame includes an eaves-like portion having a length of 0 µm or greater and 0.5 µm or less.

The pellicle frame may further include a surface metal coating layer between the pellicle film and the first frame.

An end portion of the first frame may be R-chamfered. Namely, the end portion of the first frame may include at least one curved portion.

The pellicle frame may include a pellicle film and a first frame. The pellicle film may be extended over the first frame; and an end portion of the first frame may be C-chamfered. Namely, the end portion of the first frame may include an inclining surface, and the angle made by a top surface and the inclining surface of the first frame may be 100 degrees or greater and 170 degrees or less.

The pellicle frame may be connected with a second frame; and an end portion of the second frame may be R-chamfered. Namely, the end portion of the second frame may include a curved portion.

### ADVANTAGEOUS EFFECTS OF INVENTION

In an embodiment, the present invention provides a method for producing a pellicle for EUV decreased in the amount of dust or the like attached thereto.

### BRIEF DESCRIPTION OF DRAWINGS

[FIG. 1] A schematic views illustrating a mechanism, found by the present inventors, by which a pellicle film, a pellicle frame and a pellicle are contaminated with dust.
[FIG. 2] A flowchart showing a method for producing a pellicle film, a pellicle frame and a pellicle in an embodiment according to the present invention.
[FIG. 3] Schematic views (cross-sectional views) showing steps for producing the pellicle film, the pellicle frame and the pellicle in an embodiment according to the present invention.
[FIG. 4] Schematic views (cross-sectional views) showing steps for producing the pellicle film, the pellicle frame and the pellicle in an embodiment according to the present invention.
[FIG. 5] Schematic views ((a) and (d) are plan views, (b) and (c) are cross-sectional views) showing steps for producing pellicle films, pellicle frames and pellicles in embodiments according to the present invention.
[FIG. 6] A flowchart showing a method for producing a pellicle film, a pellicle frame and a pellicle in an embodiment according to the present invention.
[FIG. 7] Schematic views (cross-sectional views) showing steps for producing the pellicle film, the pellicle frame and the pellicle in an embodiment according to the present invention.
[FIG. 8] Schematic views (cross-sectional views) showing steps for producing the pellicle film, the pellicle frame and the pellicle in an embodiment according to the present invention.
[FIG. 9] Schematic views ((a) and (c) are plan views, (b) and (d) are cross-sectional views) showing steps for producing pellicle films, pellicle frames and pellicles in embodiment according to the present invention.
[FIG. 10] Schematic views ((a) is a plan view, (b) is a cross-sectional view) showing a step for producing a pellicle film, a pellicle frame and a pellicle in an embodiment according to the present invention.

### DESCRIPTION OF EMBODIMENTS

Hereinafter, embodiments of the present invention will be described with reference to the drawings and the like. The present invention may be carried out in various forms and is not to be construed as being limited to any of the following embodiments. The present invention is limited to the scope of the claims, only. In the drawings, components may be shown schematically regarding the width, thickness, shape and the like, instead of being shown in accordance with the actual sizes, for the sake of clearer illustration. The drawings are merely examples and do not limit the interpretations of the present invention in any way. In the specification and the drawings, components that have substantially the same functions as those described before with reference to a previous drawing(s) bear the identical reference signs thereto, and detailed descriptions thereof may be omitted.

### [Definitions]

In this specification, when a certain member or region is referred to as "above (or below)" another member or region, unless there is a specific limitation, this includes not only the case where it is directly above (or directly below) the certain member or region but also the case where it is above (or below) another member or region, that is, the case when another structural component is included between above (or below) the certain member or region.

In this specification, a "pellicle film" refers to a thin film used for a pellicle. A "pellicle frame" refers to an assembly of a pellicle film and a first frame that are connected with each other. A "pellicle" refers to an assembly of a pellicle frame and a second frame that are connected with each other.

"Trimming" refers to cutting a substrate, or an assembly of the substrate and the pellicle film formed above the substrate, in accordance with a desired pellicle shape. The shape of the pellicle is often rectangular. Therefore, in this specification, an example of cutting the substrate, or an assembly of the substrate and the pellicle film formed above the substrate, into a rectangular shape is shown as a specific example of trimming.

In this specification, "back-etching" refers to a step of removing a part of the substrate while the pellicle film is left. In this specification, etching of the substrate from a rear surface thereof (surface opposite to a surface on which the pellicle film is formed) is shown as an example of back-etching.

In this specification, an "end portion" refers to a side surface, an edge or a corner edge; specifically, refers to a side surface of a substrate (first frame in the case where the substrate is used as the first frame), an edge formed by side surfaces of the substrate (first frame in the case where the substrate is used as the first frame), an edge formed by a top surface of the substrate (surface to be in contact with the pellicle film) and a side surface of the substrate, or a corner edge including a point at which a top surface and two side surfaces of the substrate cross each other.

### [Problems of the conventional technology found in the present invention]

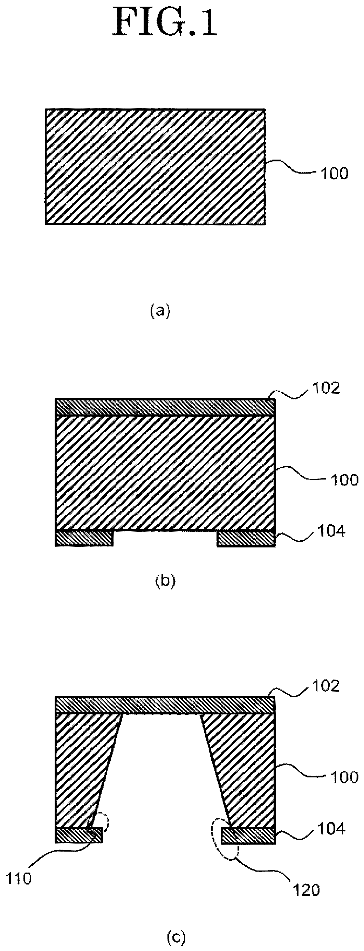

A pellicle to be produced by a pellicle production method according to the present invention is a pellicle for photolithography. First, above a substrate 100 (FIG. 1(a); for example, a silicon wafer), a pellicle film 102 is formed by a method such as CVD (Chemical Vapor Deposition; e.g., LP-CVD film formation, PE-CVD film formation, or the like), sputtering film formation or the like (FIG. 1(b)).

Then, a part of the substrate is removed while an exposure area of the pellicle film 102 is left. The part of the substrate is removed by back-etching. As described above, the "back-etching" refers to etching from a rear surface (surface of the substrate opposite to the surface having the pellicle film formed thereon).

In this step, in order to leave a part of the substrate, namely, to leave a non-exposure area of the silicon wafer in a frame shape, it is conceivable to use a SiN (silicon nitride) mask 104 on the surface opposite to the surface having the pellicle film formed thereon (on the rear surface).

However, the present inventors found the followings (1) to (4). (1) In the case where back-etching is performed on the rear surface of the substrate, an etchant is partially put on a part of the substrate that is present under the mask provided on the surface opposite to the surface having the pellicle film formed thereon (the mask provided on the rear surface); and as a result, the silicon wafer is etched under the SiN mask 104 (portion 110 enclosed by the dashed line in FIG. 1(c)). (2) Since the silicon wafer is etched under the SiN mask 104, the SiN mask is left in an eaves-like shape (portion 120 enclosed by the dashed line in FIG. 1(c); it is seen from the figure that the silicon wafer is removed, and as a result, a part of the SiN mask 104 protrudes). (3) The eaves-like portion of the SiN mask 104 is easy to be broken and generates foreign substances when being broken. (4) In the case where the pellicle film is formed of SiN and the SiN mask 104 as described above is used, it is difficult to remove only the eaves-like portion 120, which generates foreign substances, by etching or the like with no influence on the pellicle film because the pellicle film and the eaves-like portion 120 are formed of the same material. Hereinafter, the portion left in the eaves-like shape will be referred to as an "eaves-like portion".

It is conceivable to remove the eaves-like portion itself by etching. However, especially in the case where, for example, the pellicle film is formed of SiN, it is highly difficult to remove the SiN mask 104 left in the eaves-like shape by etching with no influence on the performance of the pellicle film. Thus, the eaves-like portion could not be removed.

### [Embodiment 1]

According to the present invention, the mask for back-etching is formed of a metal material (e.g., chromium (Cr) or the like) instead of the SiN mask 104, and a metal mask 204 is removed after the back-etching. According to the present invention, a mask having a significantly different etching rate from that of a material of a pellicle film 202 is used instead of the SiN mask 104, so that the mask is removed with no influence on a substrate 200 or the pellicle film 202. Thus, the mask is not left in the eaves-like shape, and the eaves-like portion is not formed. As a result, dust, which would be generated as a result of the SiN mask 104 left in the eaves-like shape being broken, is not generated.

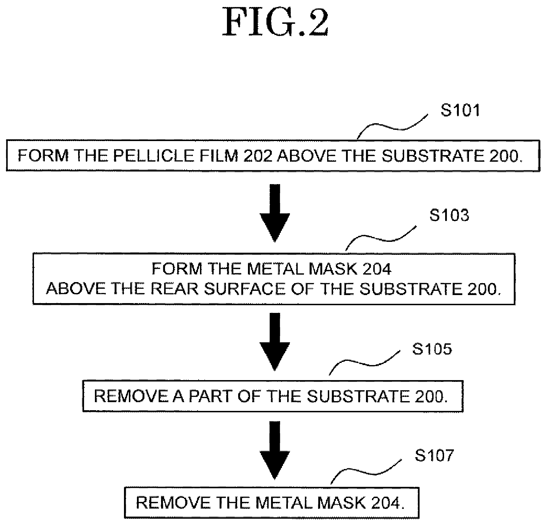

FIG. 2 is a flowchart showing a method for producing a pellicle in this embodiment. With reference to FIG. 2, the method for producing a pellicle film and a pellicle frame according to the present invention will be described. First, (1) the pellicle film 202 is formed above one surface of the substrate 200 (silicon wafer or the like) (S101), and the metal mask 204 is formed on a surface of the substrate 200 opposite to the surface having the pellicle film 202 formed thereon (on a rear surface) (S103).

First, the substrate 200 does not need to be a silicon wafer substrate. The shape of the substrate is not limited to a true circle, and the substrate may have an orientation flat, a notch or the like formed therein. The pellicle film does not need to be formed above the entire surface of the substrate.

It is preferred that the substrate 200, the pellicle film is to be formed, is formed of a material containing at least one of silicon, sapphire and silicon carbide. It is more preferred that the substrate 200 is formed of a material containing silicon, with which the substrate 200 may easily have a large area size.

There is no specific limitation on materials of the pellicle film, although there is an issue of compatibility between the substrate and the pellicle film to be stacked above the substrate, such that in the case where the pellicle film 202 formed of a silicon-based material is to be stacked above the substrate, it is preferred that the substrate is a silicon wafer substrate because of ease of stacking. For example, it is preferred that the pellicle film 202 is formed of a SiN film, a carbon-based film (e.g., graphene film, carbon nanotube film formed by spin coating, carbon nanosheet, or the like), a polycrystalline silicon film, or a stack structure including a plurality of layers of such materials. Among these materials, it is preferred that the pellicle film 202 is formed of a stack structure including three layers of a first SiN (silicon nitride) layer, a polycrystalline layer and a second SiN (silicon nitride) layer or formed of a carbon-based film.

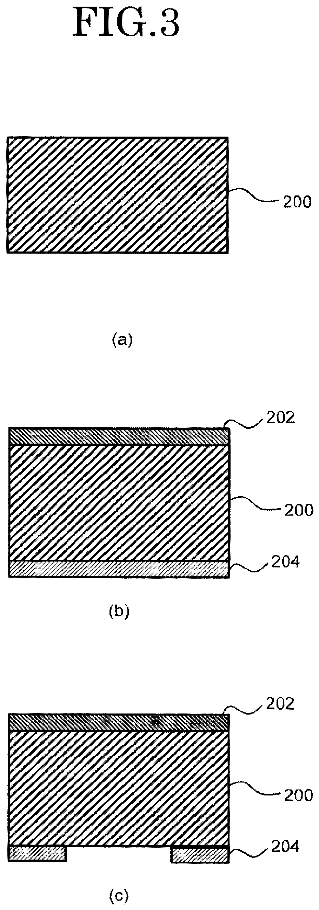

The pellicle film 202 has a thickness of about 10 nm or greater and about 100 nm or less, preferably 20 nm or greater and 60 nm or less because the pellicle film 202 needs to transmit EUV. In the case where the pellicle film has a stack structure including three layers of a first silicon nitride layer, a polycrystalline silicon layer and a second silicon nitride layer (not shown), the first silicon nitride layer may have a thickness of 1 nm or greater and 5 nm or less, the polycrystalline silicon layer may have a thickness of 30 nm or greater and 60 nm or less, and the second silicon nitride layer may have a thickness of 1 nm or greater and 5 nm or less. More preferably, the first silicon nitride layer may have a thickness of 1.5 nm or greater and 3 nm or less, the polycrystalline silicon layer may have a thickness of 30 nm or greater and 50 nm or less, and the second silicon nitride layer may have a thickness of 1.5 nm or greater and 3 nm or less. In the above step (S103), the metal mask 204 (e.g., chromium (Cr), titanium (Ti), nickel (Ni), copper (Cu), gold (Au), tungsten (W), molybdenum (Mo), iron (Fe), stainless steel, or the like) is provided on the surface opposite to the surface having the pellicle film formed thereon (FIG. 3(b)), and then is removed by etching except for a region that is required as a mask (FIG. 3(c)). Alternatively, the pellicle film 202 may be formed on both of two surfaces of the substrate 200, the pellicle film 202 may be removed from one of the surfaces, and the metal mask 204 may be formed and then removed except for a region that is required as a mask.

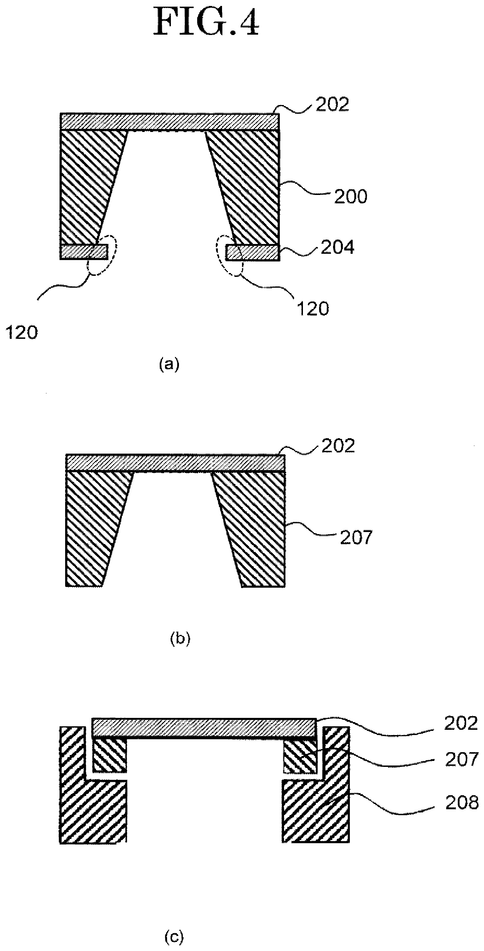

Next, (2) a part of the substrate is removed from the rear surface thereof, namely, from the side of the metal mask, (the part of the substrate is back-etched) until the pellicle 202 is exposed (S105; FIG. 4(a)). At the time of back-etching, the silicon wafer may be left, except for an exposure area, in a frame shape for the purpose of concurrently forming a first frame 207 to be connected with the pellicle film 202. Namely, in this case, the region of the substrate that is not removed becomes the first frame 207. In this manner, the pellicle frame may be produced while a step of extending the pellicle film over the first frame is omitted.

The back-etching is performed by use of an etchant (first etching agent) that does not easily dissolve the pellicle film or the metal mask but dissolves the substrate. The material to be used as the etchant (first etching agent) is selected in accordance with the materials of the substrate, the pellicle film and the metal mask. The first etching agent may be formed of, for example, potassium hydroxide (KOH), tetramethylammonium hydroxide (TMAH) or the like, but is not limited to being formed of any of these materials.

There is no specific limitation on the shape of the frame. A relatively large region of the substrate may be left as the frame from the point of view of increasing the strength. Etching may be performed in a state that a different frame is attached to a portion to be a frame before the etching. By attaching the different frame, the frame can be reinforced. As the different frame, for example, a second frame 208 may be used. In a later step, the second frame 208 may be connected with the pellicle frame, in addition to the first frame 207. It should be noted that since the pellicle for EUV is limited in the height thereof, it is preferred that the pellicle film and the frame have a total height of 2 mm or less. The second frame 208 to be connected with the pellicle frame may have a jig hole formed therein.

The pellicle frame (assembly of the pellicle film and the first frame connected with the pellicle film) is connected with the second frame, and as a result, the pellicle is produced (FIG. 4(c)). The pellicle frame (assembly of the pellicle film and the first frame connected with the pellicle film) and the second frame may be connected with each other by a pin. More specifically, a pin hole may be formed at an edge, along a side or the like of the pellicle frame, a pin hole may be formed at a position in the second frame that overlaps the pin hole of the pellicle frame, and the pellicle frame and the second frame may be connected with each other by a pin.

The present invention may include a step of removing particles. Examples of a method for removing the particles may include, for example, a wet cleaning method, a mechanical cleaning method, a dry-cleaning method, and the like. The method for removing the particles is not limited to any of these methods. The wet cleaning method may be RCA cleaning such as SC1 cleaning or SC2 cleaning. The SC1 cleaning has a function of cleaning particles with ammonia and hydrogen peroxide. The SC2 cleaning has a function of cleaning heavy metal with hydrochloric acid and hydrogen peroxide. Other examples of the wet cleaning include cleaning with pure water and cleaning with an organic solvent. Examples of the wet cleaning also include cleaning with sulfuric acid-hydrogen peroxide washing (mixture of sulfuric acid and hydrogen peroxide), cleaning with buffered hydrofluoric acid (mixture of hydrofluoric acid and ammonium fluoride), cleaning with hydrofluoric acid, and the like. These types of cleaning may be combined and performed in any order. Examples of the mechanical cleaning include brush cleaning, swing cleaning, ultrasonic cleaning, and high pressure spraying of aerosol such as argon or the like. Examples of the dry cleaning include ashing cleaning with O₂ plasma, argon sputtering, and the like.

Then, (3) the metal mask left on the rear surface is removed (S107). In this step (S107), the metal mask is removed by use of a material that does not easily dissolve the substrate 200 or the pellicle film 202 but dissolves only the metal mask 204.

The material usable as a remover (second etching agent) for the metal mask is selected in accordance with the materials of the substrate, the pellicle film and the metal mask. Preferred combinations of materials are as follows. In the case where the substrate is formed of silicon wafer, the pellicle film is formed of SiN and the metal mask is formed of chromium, it is preferred to use ceric ammonium nitrate as the remover (second etching agent) for the metal mask. The following table shows preferred combinations of materials of the pellicle film 202, the metal mask 204, the etchant (first etching agent) and the remover (second etching agent).

**[Table 1]**

| Pellicle film (outermos t surface) | Mask | Etchant | Remover |
|---|---|---|---|
| SiN or C | Cr | KOH (potassium hydroxide) | Cerium diammonium nitrate |
| | | TMAH (tetramethylammonium hydroxide) | Hydrochloric acid |
| | | | Hydrochloric acid + nitric acid |
| | | PureEtch 160 (Hayashi Junyaku Kogyo K.K.) | WCR/WQC (ADEKA Corporation) |
| | | | PureEtch CR (Hayashi Junyaku Kogyo K.K.) |
| | Ti | | Hydrochloric acid + nitric acid |
| | | | WTI (ADEKA Corporation) |
| | | | PureEtch TE (Hayashi Junyaku Kogyo K.K.) |
| | Ni | | Sulfuric acid + hydrogen peroxide |
| | | | Sulfuric acid + acetic acid |
| | | | Hydrochloric acid |
| | | | Cerium diammonium nitrate |
| | Cu | | Sulfuric acid + hydrogen peroxide |
| | | | Sulfuric acid + acetic acid |
| | | | Acetic acid + hydrogen peroxide |
| | | | Cerium diammonium nitrate |
| | | | WAD, DP (ADEKA Corporation) |
| | | | PureEtch C (Hayashi Junyaku Kogyo K.K.) |
| | Au | | Hydrochloric acid + nitric acid |
| | | | Potassium iodide |
| | | | Iodine |
| | W | | W (ADEKA Corporation) |
| | | | PureEtch W (Hayashi Junyaku Kogyo K.K.) |
| | Mo | | PureEtch AS (Hayashi Junyaku Kogyo K.K.) |
| SiN | SiN | | Hydrofluoric acid: dissolves pellicle film |

With the above-described production method, a pellicle film and a pellicle frame provided with a mask having a length of the eaves-like portion of 0.5 µm or less, preferably 0.01 µm or less, more preferably 0 µm (no eaves-like portion) may be produced. Thus, a pellicle film, a pellicle frame and a pellicle with a decreased amount of dust are obtained. As long as having a length within the above-described numerical range, the eaves-like portion has no influence on the drawings performed by photolithography when the pellicle is used as a pellicle for EUV.

According to the present invention, the substrate, the first frame or the second frame may be chamfered in at least one position. In this specification, "chamfering" refers to a concept encompassing R-chamfering and C-chamfering. "R-chamfering" refers to forming a curved portion by processing at least one end portion (side surface, edge, corner edge, etc.) of the substrate, the first frame (encompassing the first frame obtained as a result of the substrate being back-etched), or the second frame. In this specification, "C-chamfering" refers to shaving the at least one end portion obliquely (at an angle of 100 degrees or higher and 170 degrees or less). Such processing removes a cusp (acute angle portion) and thus chipped-off pieces are not easily generated even if the pellicle collides against some member during the transportation or handling after the production.

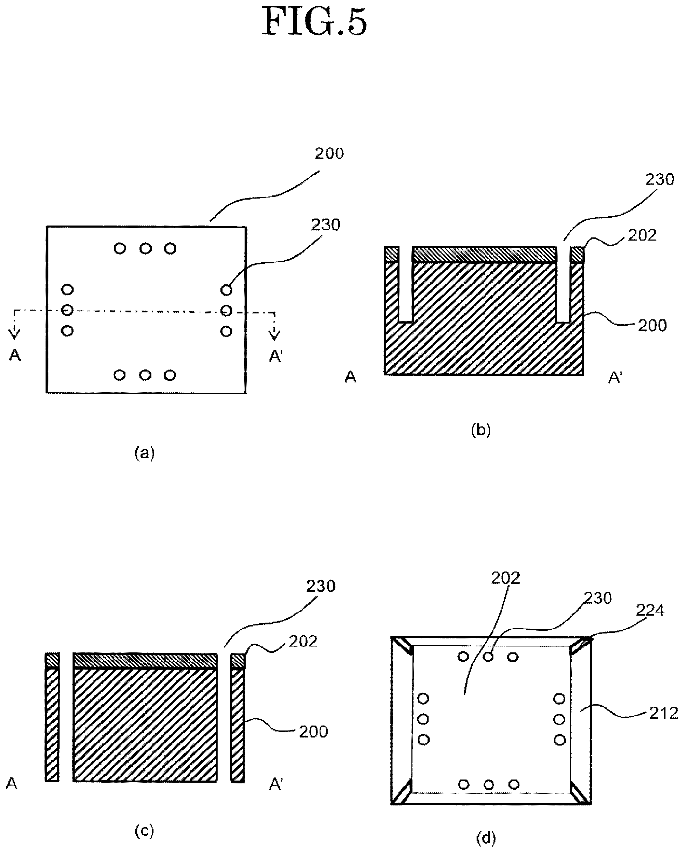

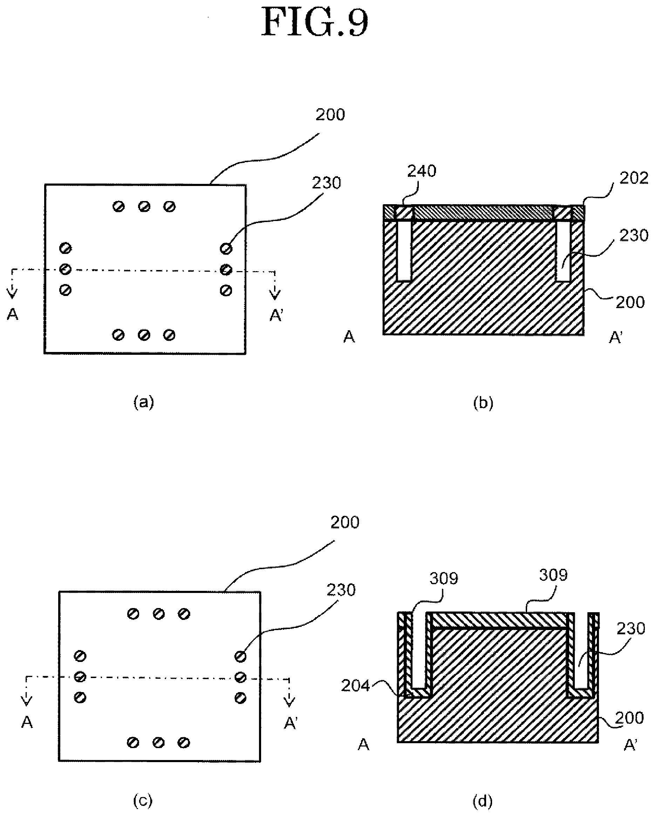

According to the present invention, at least one hole may be formed in the substrate 200 (FIG. 5). In FIG. 5, holes 230 are formed in four directions of the substrate 200. FIG. 5(a) is a plan view, and FIG. 5(b) and FIG. 5(c) are each a cross-sectional view taken along line A-A' in the plan view in FIG. 5(a). As shown in FIG. 5(b), one or more holes 230 may be formed in the pellicle film 202 formed above the substrate 200. As shown in FIG. 5(b), the holes 230 do not need to run throughout the substrate 200. Needless to say, as shown in FIG. 5(c), the holes 230 may run throughout the substrate 200. As shown in FIG. 5(b) and FIG. 5(c), the holes may be formed in the pellicle film and the substrate. In the case where at least one hole is formed to run throughout the substrate and it is selected to perform trimming by etching in a trimming step, and in the case where back-etching is to be performed, the hole may be once closed before the etching in order to protect the hole, or there may be a step of protecting the hole by a resist. If the hole is formed before the etching, the hole is expanded by the etching. Therefore, it is preferred to provide a step of protecting the hole. FIG. 9(a) shows a case where the holes 230 are closed by plugs 240 as an example of protecting the holes. The plugs 240 may be formed of, for example, a film resist. The film resist is extended and is dissolved in an unnecessary region, namely, a region except for the plugs 240, so that the holes 230 are closed by the plugs 240. There is no limitation on the size of the holes 230. In the case where, for example, the holes are each to have a generally circular shape, the holes each have a diameter of about 50 µm or greater and about 2000 µm or less. Preferably, the holes each have a diameter of about 200 µm or greater and about 700 µm or less. There is no specific limitation on the shape of the holes 230. The holes 230 may be polygonal (e.g., generally quadrangular). In the case where the holes 230 are generally quadrangular, there is no limitation on the length of each side. The length of a longer side may be 100 µm or greater and 3000 µm or less, and the length of a shorter side may be 50 µm or greater and 1000 µm or less. Preferably, the length of the longer side is 150 µm or greater and 2000 µm or less, and the length of the shorter side is 100 µm or greater and 700 µm or less. As shown in FIG. 5(a), the holes 230 may be located along the side surfaces of the pellicle, but there is no specific limitation on the positions of the holes. The holes 230 may be used as jig holes or air holes for attaching the pellicle film to, or demounting the pellicle film from, the photomask. The holes are not indispensable for the pellicle.

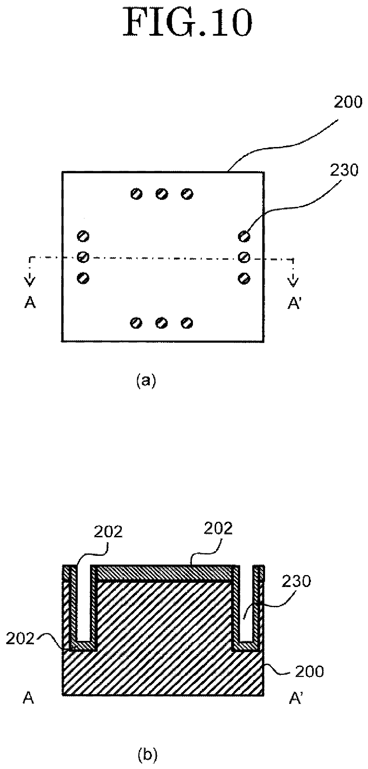

The holes 230 are formed by use of ultra-short pulse laser light or any other type of laser light, by etching, or the like. In the case where the holes 230 are formed by laser light, it is preferred to use ultra-short pulse laser light (e.g., picosecond laser light or nanosecond laser light), by which hole formation is performed with less debris, in order to form a high-quality pellicle film with little dust or the like. It should be noted that the holes do not need to be formed in this step. Alternatively, the holes 230 may be formed by etching at the time of back-etching performed on the substrate as described below. In this manner, the production process may be simplified. In this case, after the trimming is performed, the hole formation and the etching are performed at the same time. In the case where the holes 230 are formed before the back-etching of the substrate, it is preferred to provide a step of protecting the holes 230 because the holes are expanded by the etching. In the step of protecting the holes 230, it is further preferred to form a metal mask according to the present disclosure also on inner walls of the holes 230. FIG. 9(b) and FIG. 9(c) show a case where the metal mask 204 is formed on the inner walls of the holes 230 as an example of protecting the holes. Nanosecond laser light may be used under the following conditions: cycle oscillation frequency: 5 kHz or greater and 15 kHz or less; pulse energy: 5 W or greater and 15 W or less; scanning rate per second: 5 mm or greater and 30 mm or less; and number of times of scanning: 40 or greater and 300 or less. The conditions are not limited to the above. In the case where ultra-short pulse laser light is used, a dross prevention agent for laser light may be used. An example of dross prevention agent is a chemical such as CBX, which is a mixture of isopropyl alcohol (IPA) and micrographite. Such a chemical may be applied to the substrate before the holes are formed. The dross prevention agent is not limited to this. A dross prevention agent, when being used, is removed by cleaning after the holes are formed. According to another method for preventing attachment of dross, for example, helium gas may be blown to the substrate while the substrate is processed by laser light. Thus, the attachment of dross may be suppressed. The holes 230 may be formed in the substrate before the pellicle film is formed. The holes may be formed in the substrate by use of laser light as described above or wet etching. In the case where wet etching is used, the holes are formed as follows, for example. An SiO₂ layer is formed as a mask on the substrate, the SiO₂ layer is exposed to light by a common method to form a certain pattern for the holes, the substrate is etched by use of the SiO₂ layer as a mask, and the SiO₂ layer is removed. Thus, the holes are formed. In the case where the holes are formed in substrate before the pellicle film is formed, it is important that the contaminants generated by the processing performed to form the holes 230 should be completely removed before the pellicle film is formed. In order to completely remove the contaminants, both of the surfaces of the substrate are polished and cleaned after the holes 230 are formed. In this manner, the substrate may have a level of cleanliness corresponding to the level of cleanliness of the Si substrate in an initial state. This step of completely removing the contaminants is performed, so that the finished pellicle film is in a good state with few defects such as pinholes or the like. In order to protect the holes 230 against back-etching, a mask needs to be formed on the inner walls of the holes 230, like in the case where the holes 230 are formed by use of laser light. The mask may be a metal mask. Alternatively, if the pellicle film is formed on the inner walls, the pellicle film formed on the inner walls of the holes 230 may be used as the mask. FIG. 10(a) and FIG. 10(b) show a case where the pellicle film 202 is formed on the inner walls of the holes 230 as an example of protecting the holes. The pellicle film 202 formed on the inner walls in FIG. 10(b) is usable as a mask.

As shown in FIG. 5(d), as a trimming method with little dust generation, an adhesive sheet 212 having stretchability and lowered adhesive strength when subjected to external stimulation is affixed to both sides of the substrate, a bridge 224 is made inside of the substrate of the portion to which the adhesive sheet is attached, after that, trimming may be performed by making a cut in this bridge 224. According to the present invention, only the substrate may be trimmed, or the pellicle film formed above the substrate may be trimmed together with the substrate.

It is conceivable to perform trimming such that the substrate becomes, for example, rectangular. There is no specific limitation on the shape of the post-trimming shape of the substrate. The post-trimming substrate may have any shape. There is no specific limitation on the method of trimming. For example, there is a method of mechanically applying force to cut the pellicle film and the substrate, and it is also possible to cut the pellicle film and the substrate by laser cutting, laser half-cutting (stealth dicing), blade dicing, sandblasting, crystal anisotropic etching or dry etching. A technique that does not generate much dust of foreign substance particles at the time of trimming is preferred. After the back-etching, cleaning cannot be performed because the pellicle film is extremely thin. However, in the case where a step resulting in generating dust, such as a trimming step or the like, is performed before the back-etching, cleaning may be performed before the back-etching. Thus, a pellicle film, a pellicle frame and a pellicle with little dust may be produced.

### [Modifications]

Usually, the emissivity of a substance (ratio of the energy of light released by the substance by heat radiation with respect to the energy of light released by a black body having the same temperature as that of the substance (ratio of the radiance with respect to the black body radiance)) is generally in proportion to the thickness of the layer of the substance. Therefore, in the case where the layer is thin, the emissivity is low, in general. However, there are some metal materials having a locally improved emissivity in an area of the layer that is very thin. For example, ruthenium (Ru) and gold (Au) each have a locally improved emissivity in an area of the layer that is very thin. Since ruthenium (Ru) and gold (Au) have different values of emissivity, an appropriate material may be selected in accordance with the performance required of heat release.

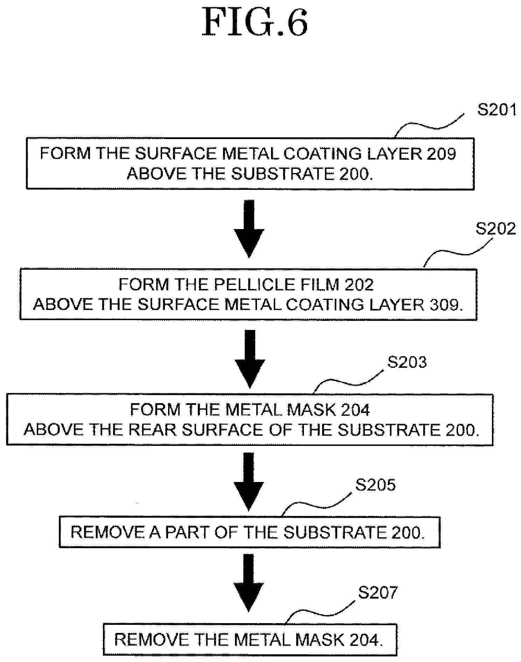

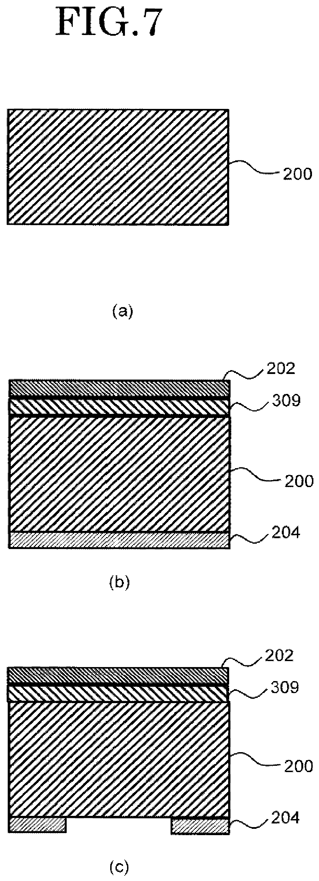

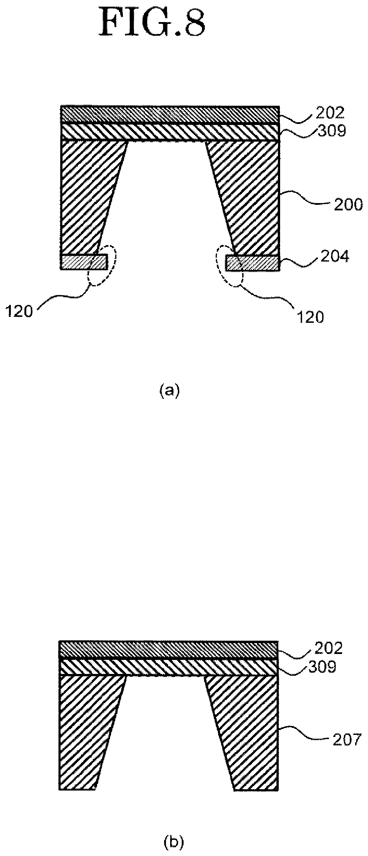

In one embodiment according to the present invention, a surface metal coating layer 309 may be provided between the substrate 200 and the pellicle film 202 (FIG. 6 (S201)). The surface metal coating layer 309 is provided, so that even in the case where a high level of optical energy is given to the pellicle film, the heat may be released so as not to damage the pellicle film. In this case, step S201 is added to the method described in embodiment 1. Except for this, the methods are the same as each other. FIG. 7 and FIG. 8 provide schematic cross-sectional views of the production method in the case where the surface metal coating layer 309 is used. In order to allow the pellicle to be produced in substantially the same manner as in the method described in embodiment 1, the surface metal coating layer 309 needs to be formed of a material fulfilling the following conditions.

First, the material needs to have a high radiance even in the case where the layer of the material is thin, to have a high EUV transmittance, and not to be easily etched away by a remover (second etching agent) as a material removing the mask material. For example, ruthenium (Ru) is preferred. Since ruthenium (Ru) is not easily etched away by a remover (second etching agent) as a material removing the mask material, the mask is not left in an eaves-like shape even in the case of being used for the production method described in embodiment 1.

A preferable combination of a pellicle film, the mask and the etching agent including the surface metal coating layer 309: the surface metal coating layer 309 is formed of ruthenium (Ru); the pellicle film is formed of silicon nitride (SiN) layer, is formed of a stack structure including three layers of a first SiN layer, a polycrystalline silicon layer and a second SiN layer, or is formed of a carbon-based film; the mask is formed of chromium (Cr); and the remover (second etching agent) as a material removing Cr used to form the metal mask is formed of cerium diammonium nitrate, hydrochloric acid, or hydrochloric acid and nitric acid. The carbon-based film is usable because the carbon-based film is not easily etched away by a material removing the metal mask, for example, cerium diammonium nitrate or the like, like silicon nitride (SiN).

### [EXAMPLES]

First, an 8-inch silicon wafer having a thickness of 725 µm was prepared as a substrate.

Next, silicon nitride was deposited to have a thickness of 5 nm on both of two surfaces of the silicon wafer by CVD, polysilicon was deposited thereon to have a thickness of 60 nm, and silicon nitride was deposited thereon to have a thickness of 5 nm. As a result, a pellicle film was formed. As a protective layer, a polycrystalline silicon film was formed to have a thickness of 400 nm.

Next, the film on one of the surfaces of the silicon wafer was removed by dry etching, and a Cr film was formed as a metal mask on this surface (surface of the silicon wafer opposite to the surface having the pellicle film formed thereon) by sputtering.

Next, the Cr film as the metal mask was patterned to have a predetermined shape for the purpose of removing a region of the metal mask corresponding to a region of the substrate that would be subjected to back-etching. As a result, the region of the metal mask corresponding to the region of the substrate that would be subjected to back-etching was removed.

Next, the silicon wafer was trimmed into a rectangular shape having a size of the pellicle. The side surfaces of the trimmed silicon wafer were chamfered (beveled), so that the edges of the silicon wafer were rounded off.

Next, the substrate was cleaned. For the cleaning, physical cleaning (rubbing cleaning) and chemical cleaning (oxidation and oxide layer removal) were used.

Next, a region of the silicon wafer where the pellicle film was to be formed was removed by back-etching. In this step, the silicon wafer was not entirely removed but was partially left such that the left part would be used as a frame. As a result of this step, the Cr film used as the etching mask included an eaves-like portion.

Next, the Cr mask was removed by etching. As a result, the eaves-like portion was removed. Thus, the problem to be solved by the present invention is solved.

### REFERENCE SIGNS LIST

- 10: Pellicle
- 100, 200: Substrate
- 102, 202: Pellicle film
- 104: SiN mask
- 120: Eaves-like portion
- 204: Metal mask
- 207: First frame
- 208: Second frame
- 212: Pressure-sensitive adhesive sheet
- 224: Bridge
- 230: Hole
- 240: Plug
- 309: Surface metal coating layer

## Claims

1. A method for producing a pellicle comprising:
forming a pellicle film (202) above a substrate (200);
forming a metal mask (204) on a surface of the substrate (200) opposite to a surface having the pellicle film (202) formed thereon;
removing a part of the substrate (200) from the side of the metal mask; (204) and
removing the metal mask (204).

2. The method for producing a pellicle according to claim 1, further comprising:
forming a surface metal coating layer (309) between the substrate (200) and the pellicle film (202).

3. The method for producing a pellicle according to claim 1, wherein the metal mask (204) is formed of chromium.

4. The method for producing a pellicle according to claim 2, wherein the surface metal coating layer (309) is formed of ruthenium.

5. The method for producing a pellicle according to claim 1, wherein the removal of the part of the substrate (200) is performed by wet etching.

## Patentansprüche

1. Verfahren zur Herstellung einer Pellikel, umfassend:
Bilden einer Pellikel-Folie (202) auf einem Substrat (200);
Bilden einer Metallmaske (204) auf einer Oberfläche des Substrats (200), die einer Oberfläche gegenüberliegt, auf der die Pellikel-Folie (202) gebildet ist;
Entfernen eines Teils des Substrats (200) von der Seite der Metallmaske (204); und
Entfernen der Metallmaske (204).

2. Verfahren zur Herstellung einer Pellikel gemäß Anspruch 1, ferner umfassend:
Bilden einer Oberflächenmetallbeschichtungsschicht (309) zwischen dem Substrat (200) und der Pellikel-Folie (202).

3. Verfahren zur Herstellung einer Pellikel gemäß Anspruch 1, wobei die Metallmaske (204) aus Chrom gebildet ist.

4. Verfahren zur Herstellung einer Pellikel gemäß Anspruch 2, wobei die Oberflächenmetallbeschichtungsschicht (309) aus Ruthenium gebildet ist.

5. Verfahren zur Herstellung einer Pellikel gemäß Anspruch 1, wobei das Entfernen des Teils des Substrats (200) mittels Nassätzen durchgeführt wird.

## Revendications

1. Procédé de production d'une pellicule, comprenant :
la formation d'un film (202) de pellicule au-dessus d'un substrat (200) ;
la formation d'un masque métallique (204) sur une surface du substrat (200) opposée à une surface présentant le film (202) de pellicule formé sur celle-ci ;
le retrait d'une partie du substrat (200) du côté du masque métallique (204) ; et
le retrait du masque métallique (204).

2. Procédé de production d'une pellicule selon la revendication 1, comprenant en outre :
la formation d'une couche (309) de revêtement métallique de surface entre le substrat (200) et le film (202) de pellicule.

3. Procédé de production d'une pellicule selon la revendication 1, dans lequel le masque métallique (204) est formé de chrome.

4. Procédé de production d'une pellicule selon la revendication 2, dans lequel la couche (309) de revêtement métallique de surface est constituée de ruthénium.

5. Procédé de production d'une pellicule selon la revendication 1, dans lequel le retrait de la partie du substrat (200) est effectué par gravure humide.
